# EUROPEAN PATENT SPECIFICATION

(11) **EP 1 804 563 B1**
(45) Date of publication and mention of the grant of the patent: **03.12.2008**
(21) Application number: 06252384.0
(22) Date of filing: 02.05.2006
(51) Int. Cl.: H05K 5/02, B29C 45/14, G11C 5/00, H01L 23/538

(54) **Structure and method for packaging flash memory cards**
Struktur und Verfahren zum Ummanteln von Flash Memory Speicherkarten
Structure et procédé pour emballer des cartes à memoire flash

(30) Priority: 28.12.2005 US 322119
(43) Date of publication of application: 04.07.2007
(73) Proprietor: Liu, Chin-Tong, Noupu South Road Hsinchu (TW)
(72) Inventor: Liu, Chin-Tong, Noupu South Road Hsinchu (TW)
(74) Representative: Gee, Steven William

(56) References cited:
- EP-A- 1 724 087
- WO-A1-00/08904
- CN-A- 1 532 039
- DE-A1-2102005 004 10
- US-A- 5 475 919
- US-A- 5 502 892
- US-A- 5 627 729
- US-A1- 2006 169 786
- US-A1- 2006 220 201

## Description

### FIELD OF THE INVENTION

The present invention generally relates to a structure and a packaging method for flash memory cards, and more specifically to a structure and a packaging method for flash memory cards using insert molding.

### BACKGROUND OF THE INVENTION

As the digital products, such as digital camera, mobile phones, PDA, are becoming popular, the consumer demands on the flash memory cards increase. The current types of the flash memory cards include compact flash (CF), card, smart media card (SMC), multimedia card (MMC), secure digital (SD) card, memory stick (MS) card, and an even newer xD-picture card. As the capacity of the memory cards increases, the cost of the loss also increases if the memory card is broken or damaged and the precious data is lost. Therefore, the manufacturers aim to improve the structure of the memory cards so that not only the capacity of the memory cards is improved, but also the strength of the structure and the water-proof effect.

Conventional memory cards are packed in a two-piece structure. That is, two pieces of thin plates sandwich the circuit board, and a high-frequency melting technique is then used to glue the two plates together to form a memory card structure. The drawback of this structure is that it is prone to breakage at the glued seam or creating small leakage gaps for humidity damaging the enclosed circuit board after a large number of repetitive insertions and ejections of the memory cards from the electronic devices. Another conventional method to manufacture memory cards is to mold frame members onto the top plate and bottom plate and thereafter join them by (ultrasonic) welding as disclosed by US 5475919, CN 1532039 and US 5502892. A number of techniques, are proposed for enhancing the structure. For further improvement, the present invention provides a structure and a method for packaging memory cards.

### SUMMARY OF THE INVENTION

The present invention has been made to overcome the aforementioned drawback of conventional structure and packaging methods. The primary object of the present invention is to provide a packaging structure that is cost-effective and has high yield rate, and a method of forming the same. The structure includes a covering layer that is made of a material used in the final insert molding to uniformly form a thin layer encompassing the outer structure of the memory card. This covering layer avoids the impact of the material on the circuit board during the insert molding so that yield rate is high. In case of defect, the structure can be disassembled, and the circuit board can be reused to reduce the cost.

Another object of the present invention is to provide a packaging structure that is water-proof, and a method of forming the same. As the covering layer of the structure is formed by insert molding, the sealing effect is good and the final structure is water-proof.

Yet another object of the present invention is to provide a structure that is applicable to a wide range of memory cards, and a method of forming the same. The structure of the present invention is applicable to any memory cards that include a two-plate structure sandwiching a circuit board.

To achieve the above object, the present invention provides a structure including a bottom plate, a circuit board, a top plate and a covering layer. The bottom plate includes a concave for housing the circuit board, and the top plate covers the bottom plate and the most of the circuit board so that only the electrical connection part of the circuit board is exposed. The covering layer is made of the material used in the insert molding process to form a thin layer to cover both the bottom plate and the top plate and the seam between the two plates. The covering layer gives the final structure a monolithic appearance so that the sealing is water-proof.

The foregoing and other objects, features, aspects and advantages of the present invention will become better understood from a careful reading of a detailed description provided herein below with appropriate reference to the accompanying drawings.

### BRIEF DESCRIPTION OF THE DRAWINGS

The present invention can be understood in more detail by reading the subsequent detailed description in conjunction with the examples and references made to the accompanying drawings, wherein:
FIG. 1 shows a flowchart of a packaging method of the present invention;
FIG. 2 shows a schematic view of an embodiment of packaging an SD memory card according to the present invention;
FIG. 3A shows a schematic view of the circuit board being sandwiched by the bottom plate and the top plate before the covering layer according to the present invention;
FIG. 3B shows a cross-sectional view of FIG. 3A;
FIG. 4A shows a schematic view of the circuit board being sandwiched by the bottom plate and the top plate after the covering layer according to the present invention;
FIG. 4B shows a cross-sectional view of FIG. 4A;
FIG. 5 shows a schematic view of another embodiment of the present invention;
FIG. 6A shows a schematic view of the circuit board being sandwiched by the bottom plate and the top plate before the covering layer of FIG. 5;
FIG. 6B shows a schematic view of the circuit board being sandwiched by the bottom plate and the top plate after the covering layer of FIG. 5; and
FIG. 7 shows a schematic view of yet another embodiment of the present invention.

### DETAILED DESCRIPTION OF THE PREFERRED EMBODIMENTS

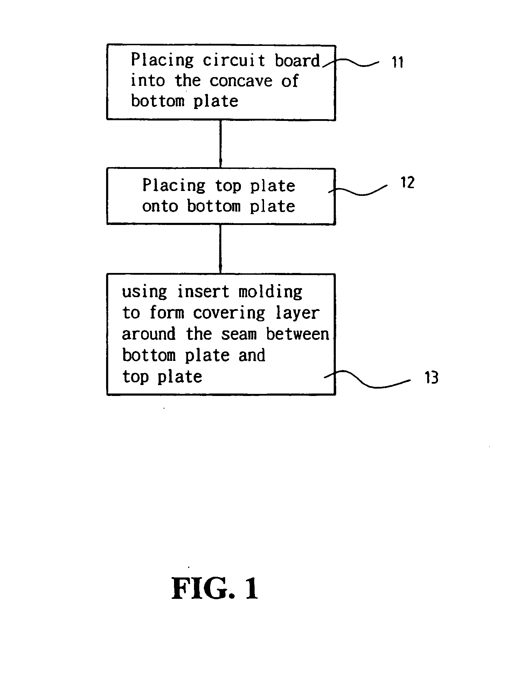

FIG. 1 shows a flowchart of the present invention, including the following steps. Step 11 is to place a circuit board onto a bottom plate. The bottom plate includes a concave to house the circuit board. The electrical connection part of the circuit board is exposed for further electrical connection. Step 12 is to place a top plate on the circuit board to cover the circuit board except the exposed electrical connection part. Finally, step 13 is to use insert molding to form a covering layer to encompassing the seam where the bottom plate meets the top plate, the surrounding area of the electrical connection part of the circuit board while exposing the electrical connection part. The hardening of the molding material will slightly melt and glue the top and bottom plates tightly to form a water-proof seal and the final structure will have a monolithic appearance of a memory card with the electrical connection part exposed for electrical connection.

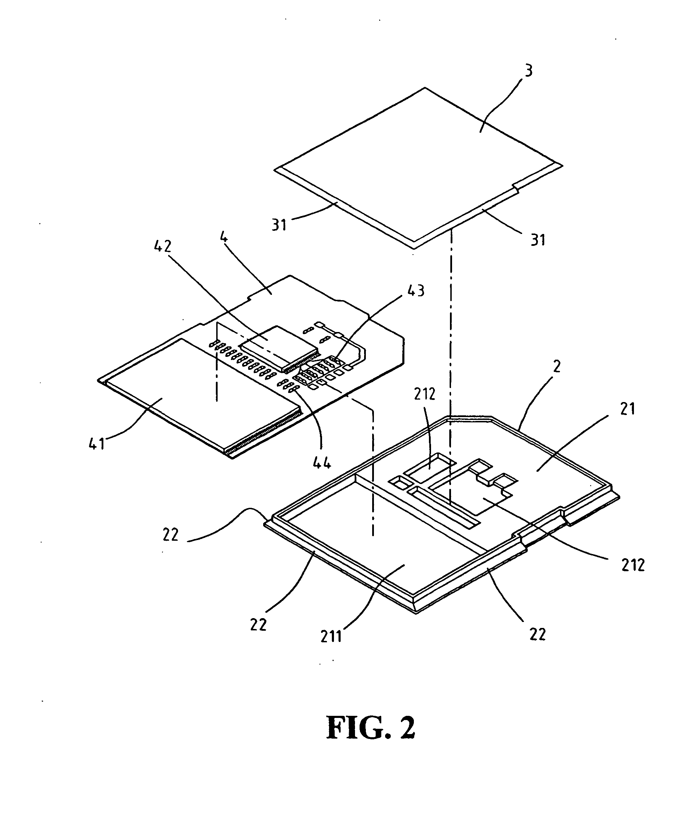

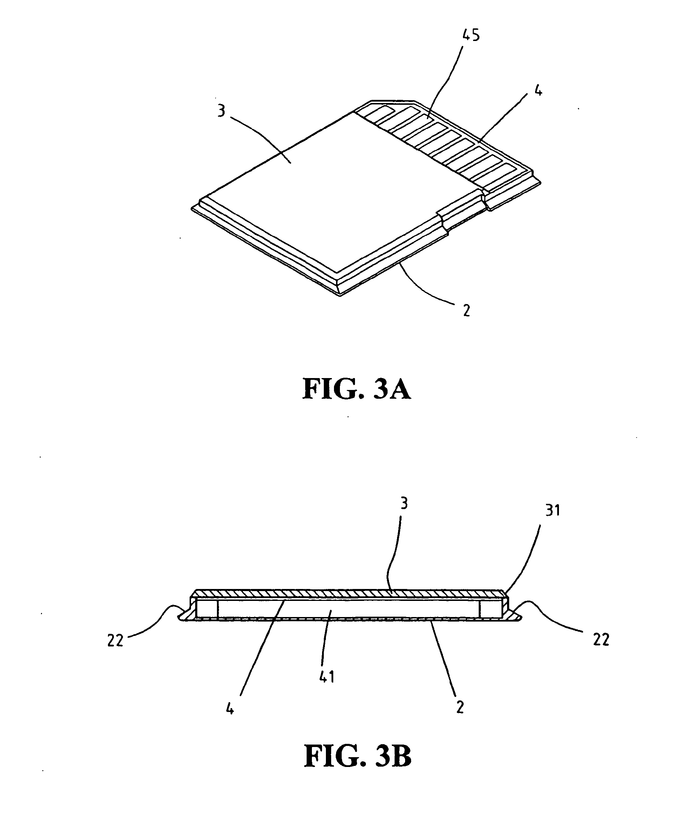

FIG. 2 shows an embodiment of packaging an SD card according to the present invention. However, the present invention is not limited to the application of SD cards. Any other equivalent types of memory cards are also within the scope of the present invention. As shown in FIG. 2, a bottom plate 2 and the top plate 3 are formed with an injection molding process in advance. The top surface of bottom plate 2 includes a concave 21. The shape of concave 21 matches the shape of a circuit board 4. Concave 21 further includes at least a deep housing cave 211 a a plurality of shallow housing caves 212. Deep housing cave 211 is for housing a memory chip 41 on circuit board 4, and shallow housing caves 212 are for housing other smaller chips 42 and solder points 43, 44 of circuit board 4. The shape of each shallow housing cave 212 should accommodate the corresponding elements on circuit board 4. When circuit board 4 is placed onto bottom plate 2, the circuitry and the solder points on circuit board 4 are not interfered. The other side of circuit board 4 includes a plurality of electrical connection parts 45, so-called gold-fingers, as shown in FIG. 3A. The total thickness of bottom plate 2 and top plate 3 is equal to the standard thickness of an SD card. As a covering layer is formed with the material during the insert molding process to cover the seam of bottom plate 2 and top plate 3, the size of bottom plate 2 should be slightly smaller than the standard size of SD cards. Furthermore, the circumference of bottom plate 2 should include a slanted slope 22 on at least two sides, and the circumference of top plate 3 should include a slanted slope 31 on at least two sides to increase the attachment during the gluing process. Top plate 3 is shorter than bottom plate 2, so that when placed on bottom plate 2, electrical connection parts 45 of circuit board 4 are exposed.

FIGS. 3A and 3B show a schematic view of the circuit board being sandwiched by the bottom plate and the top plate before the covering layer according to the present invention, which corresponds to the view after step 12 of FIG. 1 . As shown in FIGS. 3A and 3B, circuit board 4 has only the electrical connection parts exposed, and top plate 3 covers both circuit board 4 and bottom plate 2. The purpose of top plate 3 is to shoulder the pressure on circuit board 4 during the insert molding process to prevent the damage to circuit board 4.

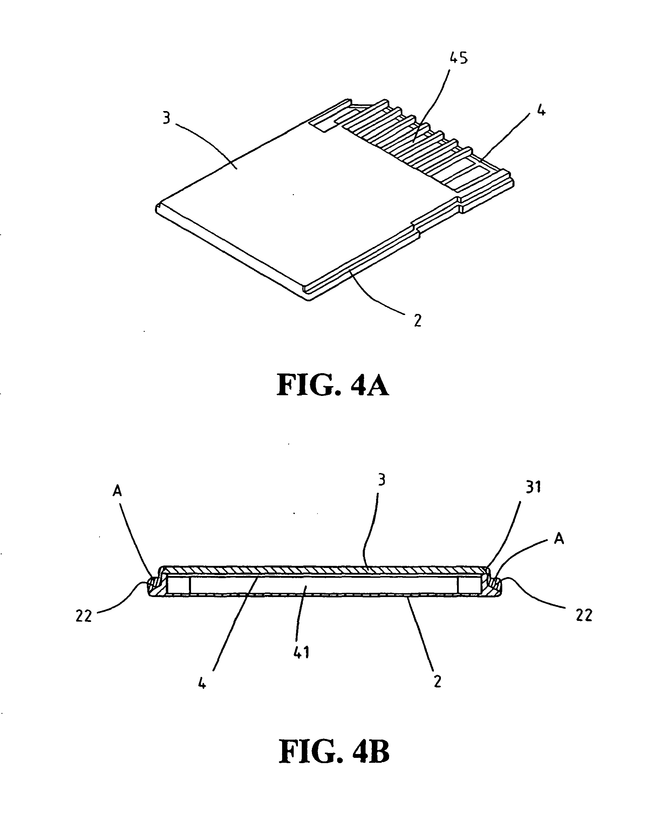

FIGS. 4A and 4B show a schematic view of the circuit board being sandwiched by the bottom plate and the top plate after the covering layer according to the present invention, which correspond to the view after step 13 of FIG. 1. As shown in FIGS. 4A and 4B, a covering layer A is made of the same material used for bottom plate 2 and top plate 3. Therefore, after covering layer A is hardened, covering layer A will form a tight seal with bottom plate 2 and top plate 3. In addition, slanted slopes 22 on bottom plate 2 and slanted slopes 31 on top plate 3 also increase the strength of the bonding. As shown, covering layer A covers the circumferences of bottom plate 2 and top plate 3, and the surrounding of exposed electrical connection parts 45 of circuit board 4. The final appearance after forming covering layer A (step 13 of FIG. 1) is a complete seal memory card with electrical connection parts exposed. Because an insert molding process is used to form covering layer A, the seal at the seam of bottom plate 2 and top plate 3 is water-proof.

In summary of the aforementioned embodiment, the structure of the present invention includes a bottom plate, a circuit board, a top plate and a covering layer. The bottom plate includes a concave for housing the circuit board, and the top plate covers the bottom plate and the most of the circuit board so that only the electrical connection part of the circuit board is exposed. Both the bottom plate and the top plate have a slanted slope on at least two sides of their circumference. The covering layer is made of the material used in the insert molding process to form a thin layer to cover both the bottom plate and the top plate and the seam between the two plates. The covering layer covers the slanted slopes of both plates to enhance the water-proof seal. The covering layer gives the final structure a monolithic appearance so that the sealing is water-proof.

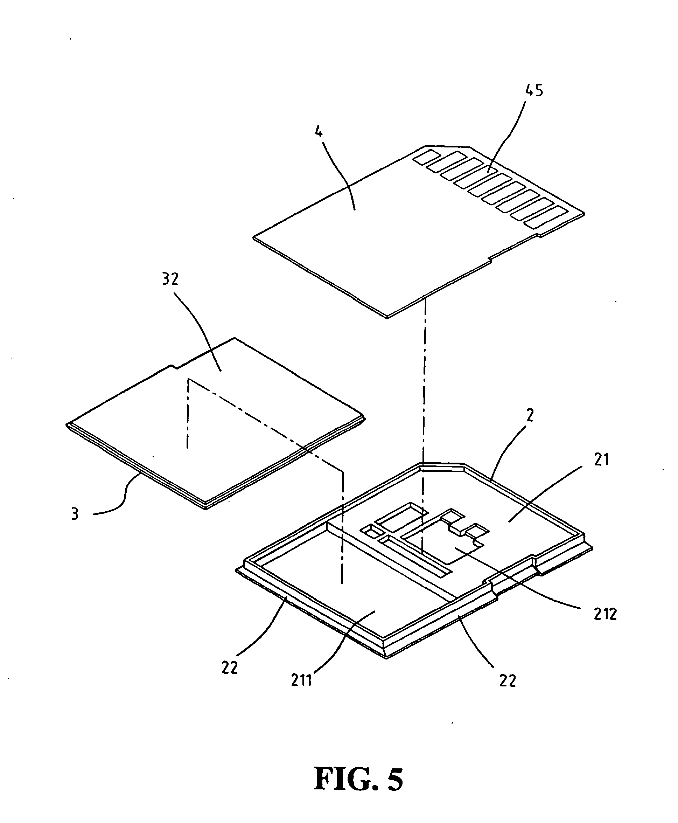

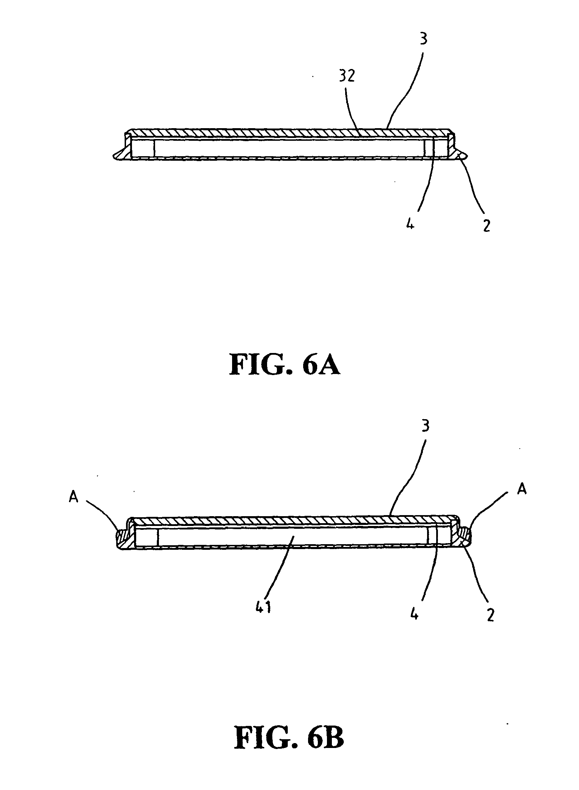

FIG. 5 shows a schematic view of another embodiment of the present invention. In this embodiment, the shape of top plate 3 includes a protruding block 32. The shape of protruding block 32 corresponds to the shape of concave 21 of bottom plate. As shown in FIG. 6A, protruding block 32 of top plate 3 is inside concave 21 of bottom plate 2 when top plate 3 is placed into bottom plate 2. The purpose of having protruding block 3 fitting inside concave 21 is to ensure that top plate will not shift due to the impact of material during the insert molding process. In addition, protruding block can also prevent the leakage of the molding material into the seam of bottom plate 2 and top plate 3. This will improve the yield rate. FIG. 6B shows a cross-sectional view of the final structure.

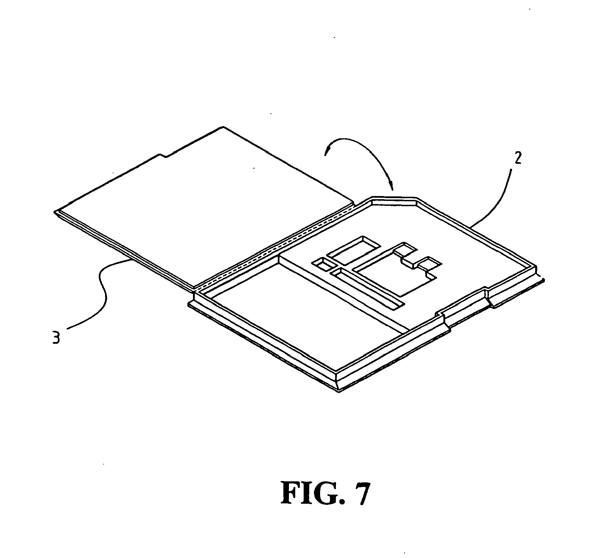

FIG. 7 shows a schematic view of yet another embodiment of the present invention. In this embodiment, one side of bottom plate 2 is attached to one side of top plate 3. The thickness of this attachment is very thin so that when top plate 3 covers bottom plate 2, an insert molding process can still be applied to form a covering layer on the attachment to form a memory card. The advantage of this embodiment is that bottom plate 2 and top plate 3 are monolithic and the subsequent packaging process is easier and less expensive.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A method for packaging flash memory cards, comprising the steps of:
(a) placing a circuit board (4) of said flash memory card inside a bottom plate (2);
(b) placing a top plate (3) on top of said bottom plate to cover said circuit board with only electrical connection parts of said circuit board exposed; and
(c) using an insert molding process to form a covering layer (A) on the circumference of said bottom plate and said top plate to form the shape of said flash memory card.

2. The method as claimed in claim 1, wherein said bottom plate of said step (a) further comprises a concave (21) for housing said circuit board.

3. The method as claimed in claim 1, wherein said covering layer of said step (c) covers the circumference of said bottom plate and said top plate, the surrounding of said electrical connection part, and the seam between said circuit board and said bottom and said top plates.

4. A structure for flash memory cards, comprising:
a bottom plate (2), with a concave (21),
a circuit board (4), placed inside said concave of said bottom plate;
a top plate (3), for covering said bottom plate and the most of said circuit board with only electrical connection part of said circuit board exposed; and
a covering layer (A), made of the same material as said bottom plate and said top plate on
the circumference of said bottom plate and said top plate, the surrounding of said electrical connection part, and the seam between said circuit board and said bottom
and said top plates to form the shape of said memory card.

5. The structure as claimed in claim 4, wherein said covering layer is formed by an insert molding process.

6. The structure as claimed in claim 4, wherein said concave further comprises at least a large deep housing cave (211) and a plurality of small shallow caves (212).

7. The structure as claimed in claim 4, wherein said bottom plate has a slanted slope (22) on at least two sides of the circumference.

8. The structure as claimed in claim 4, wherein said top plate has a slanted slope on at least two sides of the circumference.

9. The structure as claimed in claim 4, wherein said top plate further comprises a protruding block (32) to fit in said concave of said bottom plate.

10. The structure as claimed in claim 4, wherein one side of said bottom plate is attached to one side of said top plate, and said top plate covers said bottom plate when folded along the attached side.

## Patentansprüche

1. Verfahren zum Verpacken von Flash-Speicherkarten, das die folgenden Schritte beinhaltet:
(a) Platzieren einer Leiterplatte (4) der genannten Flash-Speicherkarte in einer Bodenplatte (2);
(b) Platzieren einer Deckplatte (3) auf der genannten Bodenplatte, um die genannte Leiterplatte so zu bedecken, dass nur elektrische Verbindungsteile der genannten Leiterplatte exponiert sind; und
(c) Bilden einer Deckschicht (A) auf dem Umfang der genannten Bodenplatte und der genannten Deckplatte mit einem Zweistufen-Spritzgießverfahren, um die Form der genannten Flash-Speicherkarte zu bilden.

2. Verfahren nach Anspruch 1, wobei die genannte Bodenplatte des genannten Schrittes (a) ferner eine Vertiefung (21) zum Aufnehmen der genannten Leiterplatte aufweist.

3. Verfahren nach Anspruch 1, wobei die genannte Deckschicht aus dem genannten Schritt (c) den Umfang der genannten Bodenplatte und der genannten Deckplatte, die Umgebung des genannten elektrischen Verbindungsteils und die Naht zwischen der genannten Leiterplatte und der genannten Boden- und Deckplatte bedeckt.

4. Konstruktion für Flash-Speicherkarten, die Folgendes umfasst:
eine Bodenplatte (2) mit einer Vertiefung (21),
eine Leiterplatte (4), die in der genannten Vertiefung der genannten Bodenplatte platziert ist;
eine Deckplatte (3) zum Bedecken der genannten Bodenplatte und des größten Teils der genannten Leiterplatte so, dass nur der elektrische Verbindungsteil der genannten Leiterplatte exponiert ist; und
eine Deckschicht (A) aus demselben Material wie die genannte Bodenplatte und die genannte Deckplatte auf dem Umfang der genannten Bodenplatte und der genannten Deckplatte, der Umgebung des genannten elektrischen Verbindungsteils und der Naht zwischen der genannten Leiterplatte und der genannten Boden- und Deckplatte, um die Form der genannten Speicherkarte zu bilden.

5. Konstruktion nach Anspruch 4, wobei die genannte Deckschicht mit einem Zweistufen-Spritzgießverfahren gebildet ist.

6. Konstruktion nach Anspruch 4, wobei die genannte Vertiefung ferner wenigstens eine große, tiefe Gehäuseaushöhlung (211) und mehrere kleine flache Aushöhlungen (212) umfasst.

7. Konstruktion nach Anspruch 4, wobei die genannte Bodenplatte eine Abschrägung (22) auf wenigstens zwei Seiten des Umfangs hat.

8. Konstruktion nach Anspruch 4, wobei die genannte Deckplatte eine Abschrägung auf wenigstens zwei Seiten des Umfangs hat.

9. Konstruktion nach Anspruch 4, wobei die genannte Deckplatte ferner ein vorstehendes Stück (32) umfasst, das in die genannte Vertiefung der genannten Bodenplatte passt.

10. Konstruktion nach Anspruch 4, wobei eine Seite der genannten Bodenplatte an einer Seite der genannten Deckplatte angebracht ist und die genannte Deckplatte die genannte Bodenplatte bedeckt, wenn sie entlang der angebrachten Seite geklappt wird.

## Revendications

1. Procédé destiné à emballer des cartes à mémoire flash, comportant les étapes consistant à :
(a) placer une carte à circuit imprimé (4) de ladite carte à mémoire flash à l'intérieur d'une plaque inférieure (2) ;
(b) placer une plaque supérieure (3) par-dessus ladite plaque inférieure afin de recouvrir ladite carte à circuit imprimé, seules les pièces de connexion électrique de ladite carte à circuit imprimé étant exposées ; et
(c) utiliser un processus de moulage par insertion afin de façonner une couche de revêtement (A) sur la circonférence de ladite plaque inférieure et de ladite plaque supérieure afin de façonner la forme de ladite carte à mémoire flash.

2. Procédé selon la revendication 1, dans lequel ladite plaque inférieure de ladite étape (a) comporte par ailleurs une partie concave (21) à des fins de logement de ladite carte à circuit imprimé.

3. Procédé selon la revendication 1, dans lequel ladite couche de revêtement de ladite étape (c) recouvre la circonférence de ladite plaque inférieure et de ladite plaque supérieure, le pourtour de ladite pièce de connexion électrique, et le joint entre ladite carte à circuit imprimé et ladite plaque inférieure et ladite plaque supérieure.

4. Structure pour cartes à mémoire flash, comportant :
une plaque inférieure (2), avec une partie concave (21) ;
une carte à circuit imprimé (4), placée à l'intérieur de ladite partie concave de ladite plaque inférieure ;
une plaque supérieure (3) destinée à recouvrir ladite plaque inférieure et la plus grande partie de ladite carte à circuit imprimé, seule la pièce de connexion électrique de ladite carte à circuit imprimé étant exposée ; et
une couche de revêtement (A) constituée de la même matière que ladite plaque inférieure et ladite plaque supérieure sur la circonférence de ladite plaque inférieure et de ladite plaque supérieure, le pourtour de ladite pièce de connexion électrique, et le joint entre ladite carte à circuit imprimé et ladite plaque inférieure et ladite plaque supérieure afin de façonner la forme de ladite carte à mémoire.

5. Structure selon la revendication 4, dans laquelle ladite couche de revêtement est façonnée par un processus de moulage par insertion.

6. Structure selon la revendication 4, dans laquelle ladite partie concave comporte par ailleurs au moins une grande cavité de logement profonde (211) et une pluralité de petites cavités peu profondes (212).

7. Structure selon la revendication 4, dans laquelle ladite plaque inférieure a une pente inclinée (22) sur au moins deux côtés de la circonférence.

8. Structure selon la revendication 4, dans laquelle ladite plaque supérieure a une pente inclinée sur au moins deux côtés de la circonférence.

9. Structure selon la revendication 4, dans laquelle ladite plaque supérieure comporte par ailleurs un bloc en saillie (32) à des fins d'insertion dans ladite partie concave de ladite plaque inférieure.

10. Structure selon la revendication 4, dans laquelle un côté de ladite plaque inférieure est attaché à un côté de ladite plaque supérieure, et ladite plaque supérieure recouvre ladite plaque inférieure lorsqu'elle est pliée le long du côté attaché.
